# DEMANDE DE BREVET EUROPEEN

(11) **EP 4 565 036 A1**
(43) Date de publication de la demande: **04.06.2025**
(21) Numéro de dépôt: 24215806.1
(22) Date de dépôt: 27.11.2024
(51) Int. Cl.: H10F 30/223, H10F 71/00, H10F 77/20, H01S 5/042, H01S 5/062, H01S 5/125, H10H 20/01

(54) **PROCÉDÉ DE FABRICATION D'UN DISPOSITIF OPTOÉLECTRONIQUE COMPRENANT UN COMPOSÉ INTERMETALLIQUE**

(30) Priorité: 30.11.2023 FR 2313376
(71) Demandeur: Commissariat à l'Energie Atomique et aux Energies Alternatives, 75015 Paris (FR)
(72) Inventeur: CARDOUX, Clément, 38054 Grenoble cedex 09 (FR); KROEMER, Eric, 38054 Grenoble cedex 09 (FR); REBOUD, Vincent, 38054 Grenoble cedex 09 (FR); RODRIGUEZ, Philippe, 38054 Grenoble cedex 09 (FR); TCHELNOKOV, Alexei, 38054 Grenoble cedex 09 (FR)
(74) Mandataire: Brevalex

(57) **Abrégé**

Le procédé de l'invention comprend une épitaxie d'une couche d'intérêt en GeSn sur une couche de croissance comprenant en GeSn de concentration en étain inférieure à celle de la couche d'intérêt; une formation d'une région active dans la couche d'intérêt, d'étendue surfacique inférieure à une première surface maximale ; un retrait d'une partie de la couche de croissance de façon à ce que l'interface entre les couches de croissance et d'intérêt en vis-à-vis de la région active soit inférieure à une deuxième surface maximale ou nulle ; une formation d'une portion métallique comportant du Ti ou du NiPt sur une partie de la couche d'intérêt ; un chauffage dans un four à une température strictement supérieure à la température d'épitaxie, pour réaliser un composé intermétallique à partir de la portion métallique ; les première et deuxième surfaces maximales étant telles que l'étain dans la région active ne ségrègue pas.

## Description

### DOMAINE TECHNIQUE

Le domaine de l'invention est celui de la réalisation d'un dispositif microélectronique ou optoélectronique à base d'un alliage de germanium et d'étain comprenant un composé intermétallique, notamment sous la forme d'un composé intermétallique de NiPt et de GeSn, ou d'un composé intermétallique de Ti et de GeSn. Le composé intermétallique est par exemple une partie d'un contact ohmique du dispositif microélectronique.

### ÉTAT DE LA TECHNIQUE ANTÉRIEURE

Les matériaux à base d'un alliage de germanium et d'étain (GeSn) peuvent être utilisés dans des sources de lumière ou des photodétecteurs opérant dans la gamme de longueurs d'onde des infrarouges moyennes (dite MWIR), par exemple à des longueurs d'onde supérieures à 1,6 µm. Plusieurs de ces dispositifs sont généralement fabriqués en parallèle sur une plaque sur laquelle repose au moins une couche à base de GeSn. Ils trouvent notamment des applications dans le domaine des connexions optiques entre puces ou microprocesseurs, des capteurs optiques d'espèces chimiques, ou des imageurs.

Les sources de lumière et les photodétecteurs à base d'un alliage de germanium et d'étain (GeSn) comprennent au moins une région active à base de GeSn dans laquelle des photons sont respectivement émis ou absorbés. Elle est généralement connectée électriquement à un circuit de lecture ou de commande ou d'alimentation comprenant des lignes métalliques et/ou des vias. Il est donc nécessaire de réaliser une connexion électrique entre le matériau à base de GeSn et le circuit. Très souvent, la connexion électrique comprend un contact ohmique, en contact physique avec le matériau à base de GeSn. Par définition, un contact électrique est dit ohmique si une variation du courant électrique le traversant est proportionnelle à une variation d'une différence de potentiel appliquée à ses bornes.

Une façon de réaliser un contact ohmique peu résistif est de former un composé intermétallique de GeSn. Le composé intermétallique présente d'autres avantages, parmi lesquels on peut citer : une bonne adhésion du contact, une faible résistivité, une bonne prédictibilité de la résistance du contact ohmique et une compatibilité avec les procédés CMOS.

Un composé intermétallique de GeSn est typiquement obtenu par chauffage d'un métal reposant sur le matériau à base de GeSn à une température suffisante pour permettre une réaction à l'état solide conduisant à la formation du composé, ainsi qu'un processus de diffusion et/ou d'inter-diffusion et/ou de nucléation impliquant des atomes du métal. Cependant, dès lors que la concentration de l'étain est supérieure à 1 % dans le germanium, celui-ci a tendance à ségréguer pendant le chauffage, rendant la source de lumière ou le photodétecteur inopérant. La ségrégation de l'étain intervient notamment lorsque la température dépasse la température d'épitaxie du matériau à base de GeSn. Par ségrégation, on entend que des atomes d'étain sortent de la maille cristalline du matériau à base de GeSn pour former une phase d'étain pur. Il est possible de visualiser un état de ségrégation d'étain par diffraction de rayons X.

Le document EP 3 945 545 A1 propose une solution pour réaliser un contact ohmique Ni(GeSn), limitant, ou même en supprimant, un phénomène de ségrégation de l'étain au niveau du contact ohmique. Une couche de nickel (Ni) est déposée sur une couche en alliage germanium-étain (GeSn). Une couche en nitrure de titane (TiN) est ensuite déposée sur la couche de nickel. La couche de TiN est éclairée par un faisceau laser impulsionnel. L'essentiel de l'énergie du faisceau est absorbé par la couche de TIN et la chaleur diffuse vers les couches de Ni et de GeSn, jusqu'à dépasser la température de fusion de l'alliage GeSn. Le laser émet des pulsations de 160 ns à une longueur d'onde de 308 nm, dans une gamme d'énergie comprise entre 0,4 J/cm² et 0,7 J/cm².

Un laser tel que celui utilisé dans le document EP 3 945 545 A1 a typiquement un faisceau de section égale à 1 cm² et balaye généralement la plaque. Il existe donc un risque que le laser chauffe la région active à une température supérieure à une température entraînant un phénomène de ségrégation de l'étain. De plus, les fours sont des moyens de chauffage généralement préférés dans l'industrie des semiconducteurs car ils sont versatiles et permettent de réduire les coûts de fabrication. Parmi ceux-ci, les outils de chauffage thermique rapide (ou Rapid Thermal Annealing, RTA, en anglais), par exemple à l'aide d'une lampe, offrent de nombreux avantages.

Il existe donc un besoin pour un procédé de réalisation d'un contact ohmique à partir d'un composé intermétallique ne risquant pas de détériorer la zone active de dispositifs à base de GeSn. Il serait de plus avantageux que le procédé puisse être mis en oeuvre dans un outil de chauffage thermique rapide.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique comprenant une région active à base d'un alliage de germanium et d'étain, et un composé intermétallique de faible résistivité, sans ségréguer l'étain de la région active.

Pour cela, l'objet de l'invention est un procédé de fabrication d'un dispositif optoélectronique comportant un contact ohmique. Le procédé comprend une étape d'épitaxie d'une couche d'intérêt à base d'un alliage de germanium et d'étain sur une couche de croissance comprenant du germanium, à une température d'épitaxie Te, telle qu'une concentration minimale en étain de la couche d'intérêt est supérieure strictement à une concentration maximale en étain de la couche de croissance, une étape de formation d'une région active dans la couche d'intérêt, d'étendue surfacique dans un plan parallèle à un plan principal de la couche d'intérêt inférieure à une première surface maximale prédéterminée, un recuit de guérison de la région active pour supprimer des dislocations de la région active, une étape de retrait d'une partie au moins de la couche de croissance de façon à ce qu'une surface de la couche de croissance en contact de la couche d'intérêt et en vis-à-vis de la région active soit inférieure à une deuxième surface maximale déterminée ou nulle, une étape de métallisation pour obtenir une portion métallique comportant un métal choisi parmi le titane ou un alliage de platine et de nickel, reposant sur une partie de la couche d'intérêt, une étape de chauffage dans un four à une température Ti strictement supérieure à la température d'épitaxie Te, pour réaliser un composé intermétallique du contact ohmique à partir de la portion métallique, comprenant du germanium, de l'étain et le métal. Les étapes d'épitaxie, de formation de la région active, de retrait, de métallisation et de chauffage sont successives. La première surface maximale et la deuxième surface maximale sont telles que l'étain dans la région active ne ségrègue pas lors de l'étape de chauffage et lors du recuit de guérison.

Certains aspects préférés mais non limitatifs de ce procédé de fabrication sont les suivants.

L'étape de retrait peut relâcher une contrainte mécanique en compression dans la région active.

Une concentration d'étain dans la région active peut être supérieure à 13 %, et une compression résiduelle de la région active à l'issue de l'étape de retrait peut être supérieure ou égale à -0,35 %.

L'étape de retrait peut comprendre un report de la couche d'intérêt sur un substrat accepteur, suivi d'un retrait total de la couche de croissance.

Le report peut être réalisé par une mise en contact d'une première couche de collage comportant un métal reposant sur la couche d'intérêt, choisi parmi le titane ou un alliage de nickel et de platine, avec une deuxième couche de collage en métal reposant sur le substrat accepteur.

L'étape de retrait peut comprendre une gravure anisotropique d'une ouverture traversante de la couche d'intérêt, suivie d'une gravure isotropique de la couche de croissance au-travers de l'ouverture traversante, sélective par rapport à la couche d'intérêt.

A l'issue de la gravure isotropique, la couche de croissance et la couche d'intérêt peuvent définir une interface ne présentant pas de partie en vis-à-vis de la région active.

La gravure anisotropique peut définir une partie périphérique de la couche d'intérêt comprenant l'interface, et une partie structurée de la couche d'intérêt comportant une portion centrale comprenant la région active, reliée à la partie périphérique par au moins deux bras tenseur opposés l'un à l'autre vis-à-vis de la portion centrale, et la gravure isotropique peut induire une contrainte en tension de la portion centrale par les bras tenseur.

L'étendue surfacique de la région active peut être délimitée par un flanc de gravure.

Le flanc de gravure peut comprendre un plan cristallin (110) ou (110) de la couche d'intérêt.

Le métal peut être du titane et la température Tᵢ de l'étape de chauffage peut être supérieure à une température pour laquelle une phase Ti₆(GeSn)₅ se forme.

Le métal peut être un alliage de platine et de nickel et la température Tᵢ de l'étape de chauffage peut être supérieure à une température pour laquelle une phase NiPt(GeSn) se forme.

Le procédé de fabrication peut comprendre une procédure préalable de détermination de la deuxième surface maximale comprenant les étapes suivantes : épitaxie d'une première couche à base de GeSn de même nature que la couche d'intérêt, sur une deuxième couche de même nature que la couche de croissance, retrait d'une partie de la deuxième couche pour réaliser un ensemble de structures de test comprenant chacune une interface entre la première et la deuxième couches, les interfaces étant de surfaces différentes, mise en oeuvre de l'étape de chauffage, repérage d'un sous-ensemble de l'ensemble de structures de test pour lequel l'étain dans la structure de test a ségrégué, définition de la deuxième surface maximale à une valeur inférieure strictement à toutes les surfaces des interfaces des structures de test du sous-ensemble.

Le recuit de guérison et l'étape de chauffage peuvent être une seule et même étape.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques en coupe d'étapes de procédé communes à un premier, un deuxième et un quatrième procédés de fabrication selon l'invention ;
les figures 2A à 2F sont des vues schématiques en coupe d'étapes d'un premier procédé de fabrication selon l'invention ;
les figures 3A à 3C sont des vues schématiques en coupe d'étapes d'un deuxième procédé de fabrication selon l'invention ;
les figures 4A à 4E sont des vues schématiques en coupe d'étapes d'un troisième procédé de fabrication selon l'invention ;
les figures 5A à 5C sont des vues schématiques d'étapes d'un quatrième procédé de fabrication selon l'invention ;
les figures 6A à 6C sont des vues schématiques en coupe d'étapes d'une procédure pour obtenir un premier seuil et un deuxième seuil surfacique de ségrégation de l'étain dans une couche à base d'un alliage de germanium et d'étain.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif optoélectronique. Ce dernier comprend une région active réalisée dans une couche d'intérêt cristalline à base d'un alliage de germanium et d'étain. La région active est contenue intégralement dans la couche d'intérêt. La couche d'intérêt est obtenue par épitaxie sur une couche de croissance cristalline à base de germanium, comprenant éventuellement une quantité d'étain inférieure strictement à une quantité d'étain de la couche d'intérêt. La région active s'étend selon une étendue surfacique dans un plan parallèle à un plan principal de la couche d'intérêt. Une portion métallique constituée d'un métal est déposée sur la couche d'intérêt. L'ensemble est chauffé dans un four, qui peut être un outil de chauffage rapide, pour réaliser un composé intermétallique comprenant du GeSn et le métal. La température du chauffage pour former le composé intermétallique sous une phase peu résistive est strictement supérieure à la température d'épitaxie, au risque de ségréguer l'étain contenu dans la région active. La couche de croissance est retirée avant le chauffage, au moins en partie, dans une zone en vis-à-vis de la région active et en contact avec la couche d'intérêt. Si la couche de croissance n'est pas retirée en totalité dans la zone, la couche d'intérêt repose sur une surface d'appui de la couche de croissance en vis-à-vis de la région active.

Or, les inventeurs ont constaté qu'il existe un premier seuil se rapportant à l'étendue surfacique de la région active, indépendamment de sa forme géométrique, au-delà duquel, c'est-à-dire lorsque l'étendue surfacique de la région active est supérieure au premier seuil, l'étain ségrègue dans la région active lors du chauffage pour former le composé intermétallique. Les inventeurs ont également constaté que, si la couche de croissance n'est pas retirée en totalité dans la zone, il existe un deuxième seuil se rapportant à la surface d'appui, indépendamment de sa forme géométrique, au-delà duquel l'étain ségrègue dans la région active lors du chauffage pour former le composé intermétallique.

Le procédé de l'invention vise à réaliser un composé intermétallique particulier par chauffage dans un four d'une structure intermédiaire comprenant la région active, cette dernière ayant une étendue surfacique et un agencement prévenant la ségrégation de l'étain lors de la réalisation du composé intermétallique. C'est-à-dire que l'étendue surfacique de la région active est en-deçà du premier seuil, et la surface d'appui est en-deçà du deuxième seuil ou inexistante, ceci afin d'obtenir le composé intermétallique à partir d'une portion métallique comprenant spécifiquement du titane ou un alliage de nickel et de platine. Ainsi, l'intégrité de la région active est préservée, et le composé intermétallique est peu résistif. La surface d'appui, lorsqu'elle est présente, et l'étendue surfacique de la région active peuvent en outre être respectivement inférieures à une deuxième surface maximale prédéterminée et une première surface maximale prédéterminée, elles-mêmes inférieures ou égales, respectivement, au deuxième seuil et au premier seuil. Les première et deuxième surfaces sont par exemple prédéterminées de façon à en outre préserver l'intégrité de la région active lors d'une étape de chauffage additionnelle, comme par exemple un recuit de guérison de la région active. Les premier et deuxième seuils, ainsi que les premières et deuxièmes surfaces maximales dépendent de nombreux paramètres, dont une concentration d'étain dans la couche d'intérêt ou une ou des contraintes mécaniques dans la couche d'intérêt et/ou dans la couche de croissance, ou un budget thermique pour réaliser le composer intermétallique.

Le dispositif optoélectronique peut par exemple être un laser, une diode électroluminescente ou une photodiode. Il peut faire partie d'un ensemble plus large, comme un circuit photonique intégré. Le composé intermétallique est par exemple une partie d'un contact ohmique du dispositif optoélectronique. Le contact ohmique peut relier électriquement la région active à un circuit électrique du dispositif optoélectronique ou externe au dispositif optoélectronique, ou à un testeur.

Par couche, on entend ici et pour la suite de la description, une étendue constituée d'une ou plusieurs sous-couches d'un matériau dont l'épaisseur suivant un axe Z est inférieure, par exemple dix fois, voire vingt fois, à ses dimensions longitudinales de largeur et de longueur dans un plan (X, Y) perpendiculaire à l'axe Z. Une couche peut être structurée.

Dans toute la description, une couche ou un matériau est à dit « à base » d'un semiconducteur lorsque la couche ou le matériau comprend majoritairement le semiconducteur, et éventuellement un ou plusieurs éléments chimiques additionnels, comme par exemple des atomes dopants. Sauf mention du contraire, le semiconducteur est sous une forme cristalline. Lorsque la couche comprend plusieurs sous-couches, chaque sous-couche comprend majoritairement le semiconducteur. La couche peut par exemple comprendre des sous-couches comprenant chacune majoritairement le semiconducteur avec des quantités d'élément chimique additionnel différentes, et/ou des éléments chimiques additionnels différents. Ainsi, une couche à base d'un alliage de germanium et d'étain peut comporter une sous-couche de germanium-étain intrinsèque, intercalée entre une sous-couche de germanium-étain dopée n et une sous-couche de germanium-étain dopée p. De même, une couche à base de germanium peut comporter un empilement de sous-couches comprenant chacune majoritairement du germanium et une concentration d'atomes d'étain, la concentration d'étain de chaque sous couche étant par exemple croissante suivant un ordonnancement des sous-couches le long d'un axe perpendiculaire à un plan principal de la couche. Une telle couche peut servir de couche tampon pour adapter un paramètre de maille d'un substrat à un paramètre de maille d'une couche épitaxiée sur la couche tampon.

Par matériau ou couche comprenant majoritairement un composé, on entend un matériau ou une couche dont au moins 50% de son volume est formé ou comporte le composé. Par exemple, une couche comprenant majoritairement un alliage de germanium (Ge) et d'étain (Sn) peut être une couche d'un matériau de formule brute SiₓGe_{y}Sn_{z} avec x < (y + z)/2.

Une concentration d'un élément chimique dans un matériau ou une couche est égale au rapport du nombre d'atomes de cet élément chimique sur le nombre total d'atomes dans le matériau ou la couche. Ainsi une couche d'un alliage de germanium et d'étain a une concentration d'étain de 13 %, si le couche consiste en 13 % d'atomes d'étain et 87 % d'atomes de germanium.

Dans toute la description, lorsqu'une surface ou une étendue surfacique est comparée à une valeur, on entend comparer l'aire de la surface ou de l'étendue surfacique à la valeur. De même, lorsqu'une surface ou une étendue surfacique est comparée à une autre surface ou une autre étendue surfacique, on entend comparer les aires des surfaces ou des étendues surfaciques.

Une région active d'un dispositif optoélectronique est une partie du dispositif destinée à émettre ou à détecter un rayonnement lumineux d'intérêt.

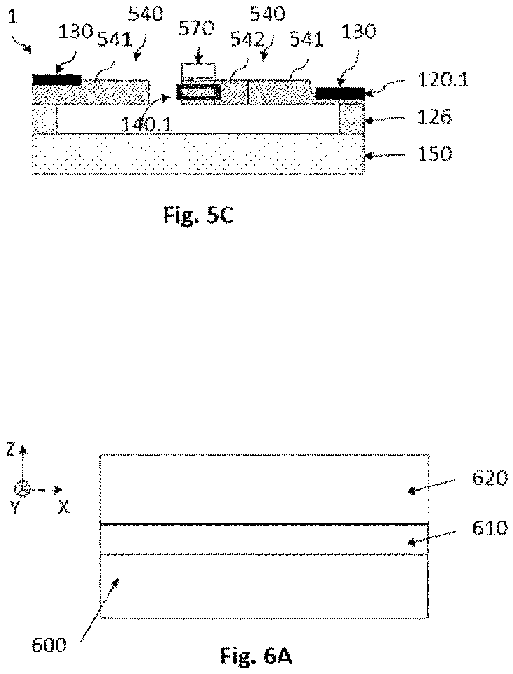

Un exemple de procédure préalable visant à déterminer le premier et le deuxième seuils va à présent être décrit en lien avec les figures 6A à 6C. Le premier et le deuxième seuils sont à déterminer au regard d'une concentration d'étain dans une première couche 620 à base d'un alliage de germanium et d'étain, et d'un budget thermique appliqué à la première couche 620 au moins suffisant pour créer un composé intermétallique à partir d'une portion métallique reposant sur la première couche 620. Le composé intermétallique n'est toutefois pas nécessairement créé lors de la procédure.

En figure 6A, une deuxième couche 610 à base de germanium est crûe par épitaxie sur un substrat 600, ici en silicium. Une première couche 620 à base d'un alliage de germanium et d'étain est ensuite crûe par épitaxie à une température d'épitaxie Tₑ, sur la deuxième couche 610. Si la deuxième couche 610 comporte de l'étain, une concentration minimale d'étain de la première couche 620 est strictement supérieure à une concentration maximale d'étain de la deuxième couche 610.

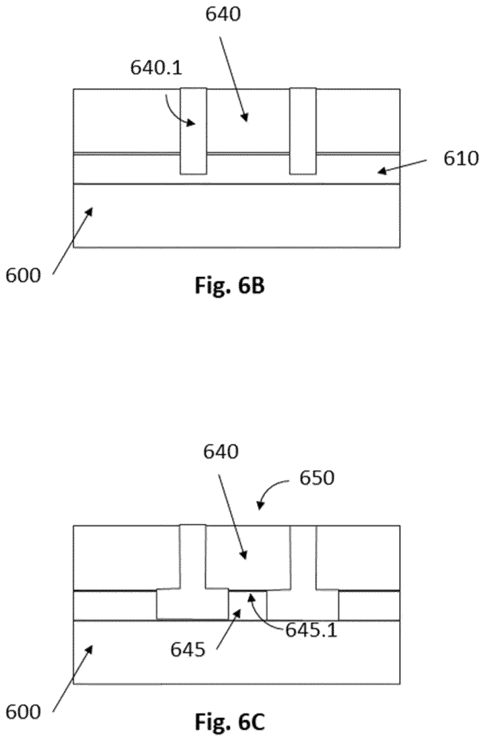

En figure 6B, la première couche 620 est gravée par une gravure anisotropique sur toute sa hauteur pour réaliser des tranchées 640.1 exposant la deuxième couche 610. Les tranchées 640.1 délimitent des socles 640 dans la première couche 620. Les tranchées peuvent se prolonger dans la deuxième couche 610, comme cela est représenté en figure 6B. Chaque socle 640 a une étendue surfacique dans un plan principal de la première couche 620, délimitée par les tranchées, dans toutes les directions du plan principal. Les socles 640 ont des étendues surfaciques de différentes surfaces, et peuvent avantageusement être homothétiques les unes des autres. Les étendues surfaciques peuvent par exemple être des disques, des rectangles ou des carrés.

En figure 6C, la deuxième couche 610 est gravée de façon isotrope au travers des tranchées 640.1, sélectivement par rapport à la première couche 620 et, avantageusement sélectivement par rapport au substrat 600. Une partie résiduelle de la deuxième couche 610 à l'issue de la gravure isotropique constitue des piédestaux 645 sur lesquels reposent les socles 640, chacun sur une surface d'appui 645.1 de la deuxième couche 610. Chaque surface d'appui 645.1 est une interface de croissance de la première couche 620 sur la deuxième couche 610. Un piédestal 645 associé à un socle 640 constitue une structure de test 650. Les structures de test 650 ont donc d'une part des étendues surfaciques de socle différentes, et d'autre part des surfaces d'appui également différentes.

Les étapes des figures 6A à 6C peuvent être reproduites sur des substrats 600 successifs, en changeant un paramètre de la gravure isotropique, comme par exemple un temps de gravure, ou une concentration d'une solution de gravure, pour obtenir un ensemble de structures de test 650 ayant des étendues surfaciques et des surfaces d'appui différentes et indépendantes les unes des autres.

L'ensemble des structures de test 650 est ensuite chauffé à une température Tᵢ strictement supérieure à la température d'épitaxie Tₑ. Cette étape de chauffage est par exemple représentative d'une étape de chauffage pour la réalisation d'un composé intermétallique, d'un recuit de guérison d'une région active, ou d'une autre étape nécessitant un budget thermique, comme la réalisation d'un empilement d'interconnexions, ou l'activation d'atomes dopants, ou d'une combinaison de ces étapes. A noter que certaines de ces étapes peuvent comporter des sous-étapes communes.

L'ensemble de structures de test 650 est ensuite inspecté avec un microscope optique. On repère les structures de test 650 pour lesquelles l'étain du socle 640 a ségrégué, et celles pour lesquelles l'étain du socle n'a pas ségrégué. On établit alors qu'il n'y a pas de ségrégation de l'étain pour les socles dont l'étendue surfacique est inférieure à une première surface maximale supérieure et dont la surface d'appui 645.1 est inférieure à une deuxième surface maximale. La première surface maximale est inférieure strictement à toutes les étendues surfaciques des socles dont l'étain a ségrégué. La deuxième surface maximale est inférieure strictement à toutes les surfaces d'appui des socles dont l'étain a ségrégué.

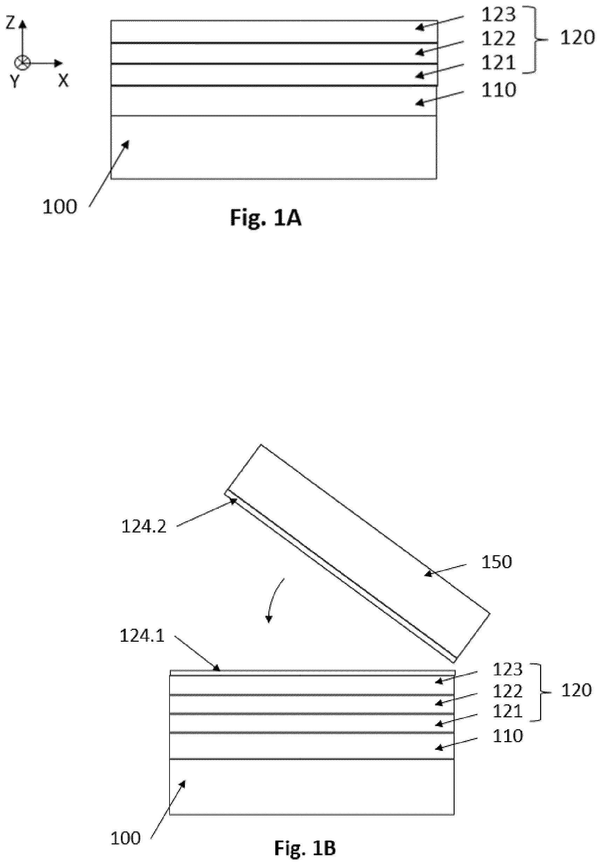

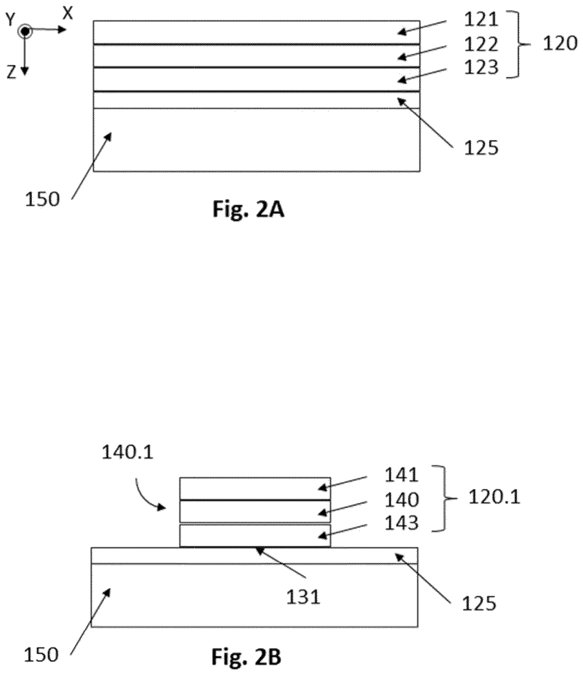

Un premier procédé de fabrication d'un dispositif optoélectronique va être décrit en lien avec les figures 1A, 1B, 2A à 2F. Le dispositif optoélectronique 1 peut être ici une diode électroluminescente ou une photodiode.

En figure 1A, une couche tampon 110 à base de germanium est crûe par épitaxie sur un substrat 100, ici en silicium d'orientation cristallographique (100). Le substrat 100 a une face supérieure plane sensiblement parallèle et opposée à une face inférieure, elle aussi plane. Le substrat 100 s'étend dans un plan principal.

On définit ici et pour la suite de la description un repère direct tridimensionnel orthogonal (X, Y, Z), où les axes X et Y forment un plan parallèle au plan principal du substrat 100, et où l'axe Z est orienté du substrat 100 vers la couche tampon 110, dans une direction sensiblement orthogonale au plan principal du substrat 100. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on s'éloigne du substrat 100, suivant la direction +Z.

La couche tampon 110 comprend ici plusieurs sous-couches. Dans l'ordre d'apparition en direction de l'axe +Z, elle peut comprendre une sous-couche inférieure en germanium, une première sous-couche en germanium-étain et une deuxième sous couche en germanium-étain ayant une concentration moyenne en étain strictement supérieure à une concentration moyenne en étain de la première sous-couche. L'épaisseur de la sous-couche de germanium est ici supérieure à l'épaisseur critique, par exemple égale à 2,5 µm . Une contrainte mécanique de la sous-couche de germanium est alors relâchée plastiquement. L'épaisseur de la première sous-couche est comprise entre 50 nm et 500 nm, avec une concentration en étain comprise entre 5 et 8 L'épaisseur de la deuxième sous-couche est comprise entre 50 nm et 500 nm, avec une concentration en étain comprise entre 8 et 12

Alternativement, la couche tampon 110 peut consister en la seule sous-couche inférieure en germanium ou comprendre un nombre quelconque de sous-couches en germanium-étain, la concentration d'étain de chaque sous couche étant alors croissante dans l'ordre d'apparition des sous-couches en direction de l'axe +Z. Il est encore possible que la couche tampon 110 soit une unique couche comprenant du germanium et une concentration en étain graduellement croissante en direction de l'axe +Z.

Une couche d'intérêt 120 cristalline en germanium-étain est ensuite épitaxiée sur la couche tampon 110 à une température d'épitaxie Tₑ. La couche tampon 110 est une couche dite de croissance, parce qu'elle est adaptée à faire croître la couche d'intérêt 120 cristalline. L'épaisseur de couche d'intérêt 120 peut être strictement inférieure à une épaisseur critique au-delà de laquelle une déformation plastique a lieu. Elle a une concentration en atomes d'étain supérieure à 1 % rapportée au nombre d'atomes de germanium. La concentration minimale en atomes d'étain de la couche d'intérêt 120 rapportée au nombre d'atomes de germanium est notamment supérieure strictement à une concentration maximale de la couche tampon 110 rapportée au nombre d'atomes de germanium. Ainsi, la couche d'intérêt 120 est contrainte en compression.

Dans toute la description, si le dispositif optoélectronique 1 est une photodiode, la concentration minimale de la couche d'intérêt 120 peut être comprise entre 2 % et 20 %. Si le dispositif optoélectronique 1 est une diode électroluminescente ou un laser, la concentration minimale de la couche d'intérêt 120 peut être comprise entre 6 % et 20 %.

Ici et dans toute la description, une concentration minimale (respectivement maximale) d'un composé dans une couche est égale au minimum (respectivement maximum) atteint par la concentration moyenne du composé dans chaque plan parallèle au plan (X, Y) de la couche, le long de l'axe Z.

Un procédé de croissance par épitaxie adapté à la croissance de la couche tampon 110 est décrit dans le document J. Aubin et al., « Growth and structural properties of step-graded, high Sn content GeSn layers on Ge », Semiconductor Science and Technology 32, 094006 (2017).

La couche d'intérêt 120 consiste ici en 3 sous-couches : une sous-couche active 122 intrinsèque ou faiblement dopée intercalée entre une sous-couche inférieure 121 dopée in-situ d'un premier type de conductivité et une sous-couche supérieure 123 dopée in-situ d'un deuxième type de conductivité opposé au premier type de conductivité. Le premier type de conductivité est ici de type n. Un procédé de croissance par épitaxie adapté à la croissance de la couche d'intérêt 120, avec ses sous-couches dopées in-situ, est décrit dans le document M. Frauenrath et al. « Advances in In Situ Boron and Phosphorous Doping of SiGeSn », ECS J. Solid State Sci. Technol. 2023, 12 064001. La température d'épitaxie Tₑ est typiquement comprise entre 301 °C et 349 °C. L'épitaxie peut par exemple être réalisée par un dépôt chimique en phase vapeur assisté par plasma à distance (ou RPCVD, pour Remote Plasma Chemical Vapour Déposition, en anglais). Elle diminue avec la concentration en étain dans la couche épitaxiée.

En figure 1B, une première couche de collage 124.1 est déposée sur la couche d'intérêt 120 et une deuxième couche de collage 124.2 est déposée sur un substrat accepteur 150. Sur des faces opposées à, respectivement, la couche d'intérêt 120 et au substrat accepteur 150, la première et la deuxième couches de collage 124.1, 124.2 peuvent comprendre toutes deux un diélectrique, de préférence amorphe, comme par exemple de l'oxyde de silicium (SiO) ou du nitrure de silicium (SiN), ou, alternativement toutes deux, un métal, par exemple choisi parmi le titane (Ti), le cuivre (Cu), le chrome (Cr), l'or (Au) ou un alliage de ces métaux. Ainsi, la première couche de collage 124.1 peut être collée à la deuxième couche de collage 124.2 par une technique de collage direct.

En outre, de façon avantageuse, la première couche de collage 124.1 comporte du titane (Ti) ou un alliage de nickel et de platine (NiPt) ou une bicouche de platine (Pt) et de nickel (Ni) en contact avec la couche d'intérêt 120, dans ce dernier cas, le platine est préférentiellement en contact avec la couche d'intérêt 120. Lorsque la première couche de collage 124.1 comporte une alliage de platine et de titane, la concentration en atomes de platine est typiquement comprise entre 5 % et 15 %, préférentiellement égale à 10 %, rapportée au nombre d'atomes de nickel. Si le substrat accepteur 150 est en silicium, la deuxième couche de collage 124.2 peut comprendre un oxyde de silicium natif, déposé ou thermique, en contact avec le substrat accepteur 150.

Dans cet exemple, la première couche de collage 124.1 consiste en 3 sous-couches, avec dans l'ordre d'apparition depuis la couche d'intérêt 120, une sous-couche de 10 nm d'épaisseur en titane (Ti), une sous-couche de 10 nm d'épaisseur en nitrure de titane (TiN) et une sous-couche en Or (Au) d'épaisseur supérieure ou égale à 200 nm, par exemple comprise entre 200 nm et 1 µm , ou entre 400 nm et 1 µm .

Dans cet exemple, le substrat accepteur 150 est en silicium et la deuxième couche de collage 124.2 consiste en 2 sous-couches, une sous-couche de chrome (Cr) de 10 nm d'épaisseur, intercalée entre une couche d'or (Au) de 200 nm et le substrat accepteur 150.

La première couche de collage 124.1 et la deuxième couche de collage 124.2 sont ensuite mises en contact et adhèrent l'une à l'autre pour assembler le substrat accepteur 150 au substrat 100 par l'intermédiaire de la couche tampon 110, la couche d'intérêt 120, la première couche de collage 124.1 et la deuxième couche de collage 124.2. A l'issue de cette étape, la première couche de collage 124.1 et la deuxième couche de collage 124.2 définissent ensemble une couche métallique 125. Par conséquent, la couche métallique 125 comporte avantageusement du titane (Ti) ou un alliage de nickel et de platine (NiPt) ou une bicouche de platine (Pt) et de nickel (Ni) en contact avec la couche d'intérêt 120, dans ce dernier cas, le platine est préférentiellement en contact avec la couche d'intérêt 120. Dans cet exemple, l'assemblage est effectué par thermocompression à 150 °C pendant 60 minutes, en appliquant une force équivalente à 1 tonne.

En figure 2A, le substrat 100 est retiré. Dans cet exemple, pour retirer le substrat 100, on effectue une étape de meulage et/ou de polissage pour laisser une épaisseur résiduelle du substrat 100 d'environ 100 µm, suivie d'une étape de gravure. La couche tampon 110 est ensuite retirée en intégralité, de façon à supprimer des dislocations de désaccord de maille dans la couche d'intérêt 120, au voisinage d'une interface entre la couche tampon 110 et la couche d'intérêt 120. Dans cet exemple, la couche tampon 110 est retirée lors d'une gravure isotrope par un plasma d'hexafluorure de soufre (SF6) et/ou de tétrafluorure de carbone (CF4). A noter que, sur les figures 2A à 2F, l'axe Z du repère orthogonal direct (X, Y, Z) est orienté depuis la couche d'intérêt vers le substrat accepteur 150.

Les inventeurs ont constaté que des dislocations de désaccord de maille (misfit dislocations, en anglais) au voisinage de l'interface entre la couche tampon 110 et la couche d'intérêt 120 initie une accumulation d'étain sous l'effet d'un chauffage. L'étain migre ensuite vers la surface par le canal de dislocations traversantes (threading dislocations, en anglais) pour diffuser le long d'une direction [110] de la couche d'intérêt 120. Un phénomène entretenu de ségrégation de l'étain peut alors s'établir. Ce phénomène peut être, au moins en partie, évité par la suppression de dislocations de désaccord de maille induite par un retrait au moins partiel de la couche tampon 110, ici totale, et peut être arrêté par la disposition d'un bord de la couche d'intérêt 120 dans un plan cristallin orthogonal à la direction [110].

En figure 2B, on grave localement la couche d'intérêt 120 sur toute son épaisseur par une gravure anisotropique, pour obtenir une couche d'intérêt structurée 120.1. A l'issue de cette étape, la couche d'intérêt structurée 120.1 comprend un flanc de gravure 140.1 sensiblement perpendiculaire au plan (X, Y) qui délimite une région de la couche d'intérêt 120 destinée à être une région active 140 du dispositif optoélectronique 1. La couche d'intérêt 120 est ici gravée par un plasma d'un mélange gazeux de CF₄, N₂ et O₂, au travers d'un masque de résine photosensible obtenue par photolithographie. Le flanc de gravure 140.1 délimite également une première région dopée 141 du premier type de conductivité, issue de la sous-couche inférieure 121, et une deuxième région dopée 143 du deuxième type de conductivité, issue de la sous-couche supérieure 123. Les première et deuxième régions dopées 141, 143 sont destinées à devenir les régions dopées p et n d'une diode PIN du dispositif optoélectronique 1.

Une partie de la couche métallique 125 en contact avec la couche d'intérêt structurée 120.1 définit une portion métallique 131 destinée à créer un composé intermétallique.

La couche d'intérêt structurée 120.1 peut présenter sur toute sa hauteur une section rectangulaire ou elliptique ou circulaire dans un plan sensiblement parallèle au plan (X, Y). Le flanc de gravure 140.1 a alors une forme, respectivement, rectangulaire, elliptique ou circulaire, dans ce plan. La région active 140 a une étendue surfacique dans un plan parallèle au plan (X, Y) délimitée par le flanc de gravure 140.1.

Optionnellement, la couche d'intérêt structurée 120.1 peut être soumise à un recuit, dit de guérison, dans un four, pendant plus de 5 minutes, à une température T_{g} supérieure strictement à la température d'épitaxie Tₑ. La température T_{g} est par exemple supérieure ou égale à 350 °C. Ainsi, des défauts cristallins de la couche d'intérêt structurée 120.1 et de la région active 140 sont supprimés. Parmi ces défauts, on compte par exemple des dislocations traversantes et/ou des lacunes et/ou des atomes interstitiels résultant de l'étape d'épitaxie de la couche d'intérêt 120. Le recuit de guérison optionnel est avantageusement réalisé à la suite de l'obtention de la couche d'intérêt structurée 120.1, mais il peut également être intéressant de l'effectuer à d'autres moment du procédé.

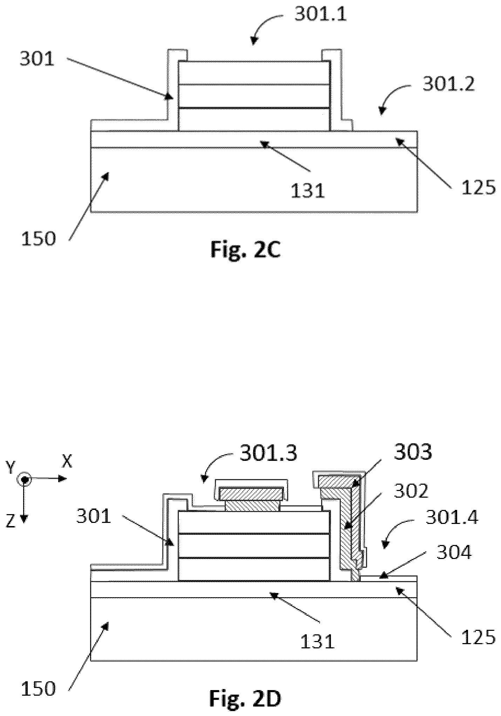

En variante, la gravure anisotropique de la couche d'intérêt 120 intervient après le dépôt de la première couche de collage 124.1 et avant l'assemblage du substrat accepteur 150 avec le substrat 100. Pour cette variante, la première couche de collage 124.1 est structurée et dessine une géométrie sensiblement identique à la couche d'intérêt structurée 120.1 dans un plan parallèle au plan (X, Y). La première couche de collage 124.1 ainsi structurée, et la deuxième couche de collage 124.2 sont ensuite mises en contact et adhèrent l'une à l'autre pour assembler le substrat accepteur 150 au substrat 100 par l'intermédiaire de la couche tampon 110, la couche d'intérêt 120, la première couche de collage 124.1 et la deuxième couche de collage 124.2. A l'issue de cette étape, la première couche de collage 124.1 structurée et la deuxième couche de collage 124.2 définissent ensemble une couche métallique 125 structurée. Une partie de la couche métallique 125 en contact avec la couche d'intérêt structurée 120.1 définit une portion métallique 131 destinée à créer un composé intermétallique. L'assemblage peut être effectué par thermocompression à une température comprise entre 100 °C et 250 °C, par exemple égale à 150 °C, pendant 60 minutes, en appliquant une force équivalente à 1 tonne. On retire ensuite le substrat comme décrit en lien avec la figure 2A. Seul le recuit de guérison optionnel peut éventuellement être effectué à l'étape de la figure 2B. Le procédé de cette variante se poursuit comme décrit en lien avec les figures 2C à 2F.

En figure 2C, on dépose un revêtement isolant 301 de façon conforme sur la couche d'intérêt structurée 120.1 et la couche métallique 125. Une première ouverture 301.1 et une deuxième ouverture 301.2, toutes deux traversantes, sont pratiquées dans le revêtement isolant 301 pour exposer respectivement, la couche d'intérêt 120 et la couche métallique 125. Les première et deuxième ouvertures 301.1, 301.2 s'étendent dans des plans sensiblement parallèles au plan (X, Y). Le revêtement isolant 301 est avantageusement une couche de passivation de la couche d'intérêt structurée 120.1. Elle passive notamment la région active 140 sur le flanc de gravure 140.1. Le revêtement isolant 301 peut être un diélectrique. Il a typiquement une épaisseur de 10 à 300 nm, préférentiellement de 150 à 200 nm. Le revêtement isolant 301 est ici en oxyde de silicium, par exemple en SiO₂.

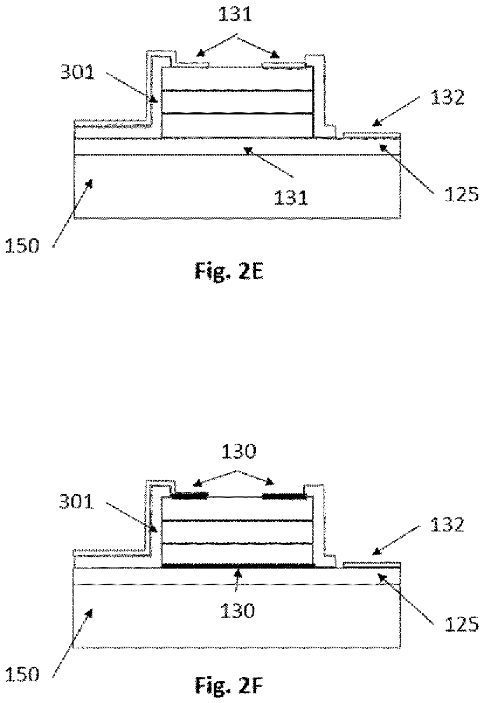

En figures 2D et 2E, on réalise des portions métalliques 131 et une portion métallique additionnelle 132 par un procédé de lithographie par décollement connu de l'homme du métier (lift-off lithography, en anglais). A noter que les portions métalliques 131 et la portion métallique additionnelle 132 peuvent également être obtenues par des étapes de masquage par photolithographie et de gravures sèches classiques. La portion métallique additionnelle 132 est optionnelle.

En figure 2D, une bicouche de résines 302, 303 sont insolées et développées, de façon à définir des motifs de résine présentant des flancs rentrants. Un motif de résine et le revêtement isolant 301 définissent ensemble une troisième ouverture 301.3 à l'intérieur de la première ouverture 301.1, exposant la couche d'intérêt structurée 120.1 dans un plan sensiblement parallèle au plan (X, Y). Optionnellement, la couche métallique 125 est exposée au niveau d'une quatrième ouverture 301.4, à l'intérieur de la deuxième ouverture 301.2.

Un revêtement métallique 304 est ensuite déposé de façon conforme. Le revêtement métallique 304 est alors en contact de la couche d'intérêt structurée 120.1 au niveau de la troisième ouverture 301.3. Il est également en contact de la couche métallique 125 au niveau de la quatrième ouverture 301.4, lorsque cette dernière existe. Le revêtement métallique 304 comporte avantageusement du titane (Ti) ou un alliage de nickel et de platine (NiPt) ou une bicouche de platine (Pt) et de nickel (Ni) en contact avec la couche d'intérêt structurée 120.1. Dans cet exemple, le revêtement métallique 304 consiste en trois sous-revêtements, un sous-revêtement de 7 nm de nitrure de titane (TiN) intercalée entre un sous-revêtement de 10 nm de titane (Ti) en contact avec la couche d'intérêt structurée 120.1, et un sous-revêtement de 400 nm d'or (Au).

Les motifs de résine sont ensuite retirés (figure 2E), par exemple par dilution dans de l'acétone pendant 25 minutes, à 40°C, en même temps que des parties du revêtement métallique 304 reposant sur les motifs de résine. A l'issue de cette étape, chaque partie du revêtement métallique 304 en contact avec la couche d'intérêt structurée 120.1 dans la troisième ouverture 301.3 définit une portion métallique 131 destinée à créer un composé intermétallique. Ici, la portion métallique additionnelle 132 consiste en la partie du revêtement métallique 304, initialement positionnée dans la quatrième ouverture 301.4, qui repose sur la couche métallique 125.

La figure 2F est une étape de réalisation d'un composé intermétallique 130. On chauffe dans un four la structure intermédiaire obtenue à l'issue des étapes de procédé de la figure 2E. Le budget thermique est suffisant pour créer le composé intermétallique 130 à partir de chaque portion métallique 131 en contact avec la couche d'intérêt structurée 120.1, comprenant du germanium, de l'étain et un métal de la portion métallique 131. L'étape de chauffage de la figure 2F est avantageusement effectuée dans un outil de chauffage thermique rapide (ou Rapid Thermal Annealing, RTA, en anglais).

Lorsque la portion métallique 131 est issue d'un revêtement métallique 304 et/ou d'une couche métallique 125 comportant du titane (Ti) ou un alliage de nickel et de platine (NiPt) ou une bicouche de platine (Pt) et de nickel (Ni), la température Tᵢ de l'étape de chauffage de la figure 2F est supérieure strictement à la température d'épitaxie Tₑ. Ainsi, l'étape de chauffage de la figure 2F participe à la suppression de défauts cristallins de la couche d'intérêt structurée 120.1 et de la région active 140, en complément ou en remplacement du recuit de guérison. Parmi ces défauts, on compte par exemple des dislocations traversantes et/ou des lacunes et/ou des atomes interstitiels résultant de l'étape d'épitaxie de la couche d'intérêt 120.

Si la portion métallique 131 comporte un alliage de platine et de nickel (NiPt), la température Tᵢ est par exemple supérieure ou égale à 350 °C, pendant une durée supérieure à 10 s, par exemple égale à 30 s, ainsi le composé intermétallique 130 comprend une phase NiPt(GeSn) qui est peu résistive. Si la portion métallique 131 comporte du titane (Ti), comme cela est le cas dans cet exemple, la température Tᵢ est par exemple supérieure ou égale à 450 °C, pendant une durée supérieure à 10 s, par exemple égale à 30 s, ainsi le composé intermétallique 130 comprend une phase Ti₆(GeSn)₅ peu résistive.

La région active 140 a une étendue surfacique inférieure à une première surface maximale et la couche tampon 110 a été entièrement retirée, de sorte que l'étain de la région active 140 ne ségrègue pas lors de l'étape de réalisation du composé intermétallique 130. La première surface maximale peut être établie par application de la procédure préalable décrite en lien avec les figures 6A à 6C, avec une deuxième couche 610 de même nature que la couche tampon 110 et une première couche 620 de même nature que la couche d'intérêt 120. Le budget thermique de l'étape de la figure 2F est appliqué pour le chauffage de l'étape de la figure 6C.

Le flanc de gravure 140.1 peut comprendre avantageusement un plan cristallin (110) ou (11̅0) de la couche d'intérêt 120 pour éviter l'éventuel phénomène entretenu de ségrégation de l'étain. Les tranchées 640.1 lors de la réalisation des structures de test de la procédure préalable comportent alors toutes avantageusement un plan cristallin (110) ou (11̅0).

La première surface maximale est par exemple égale à 2,5.10⁻⁶ cm², pour une région active 140 comprenant 13 % d'étain et un budget thermique correspondant à une température de 400°C pendant 20 minutes. Pour une région active 140 comprenant 11 % d'étain, la première surface maximale est égale à 4,5.10⁻⁶ cm² pour un budget thermique de 400°C pendant 20 minutes, et égale à 1,8.10⁻⁶ cm² pour un budget thermique de 450°C pendant 20 minutes. Pour une région active 140 comprenant 16 % d'étain, la première surface maximale est égale à 1,5.10⁻⁶ cm² pour un budget thermique de 400°C pendant 20 minutes.

Dans le dispositif optoélectronique 1 réalisé avec ce premier procédé de fabrication ou les suivants, un composé intermétallique 130 en contact avec la première région dopée 141 est connecté à un circuit électrique, par exemple d'alimentation ou de commande ou de lecture, via un contact métallique (non représenté) formé sur le composé intermétallique 130. Le composé intermétallique 130 en contact avec la deuxième région dopée 143 est connecté au circuit électrique via la couche métallique 125 et un contact métallique additionnel (non représenté), formé sur la portion métallique additionnelle 132. Les contacts métalliques peuvent comprendre du titane (Ti), de l'or (Au), de l'aluminium (AI) ou un alliage d'aluminium et de cuivre (AICu). Alternativement, les composés intermétalliques 130 peuvent être connectés au circuit électrique par une connexion filaire ou des pointes, par exemple des pointes d'un testeur.

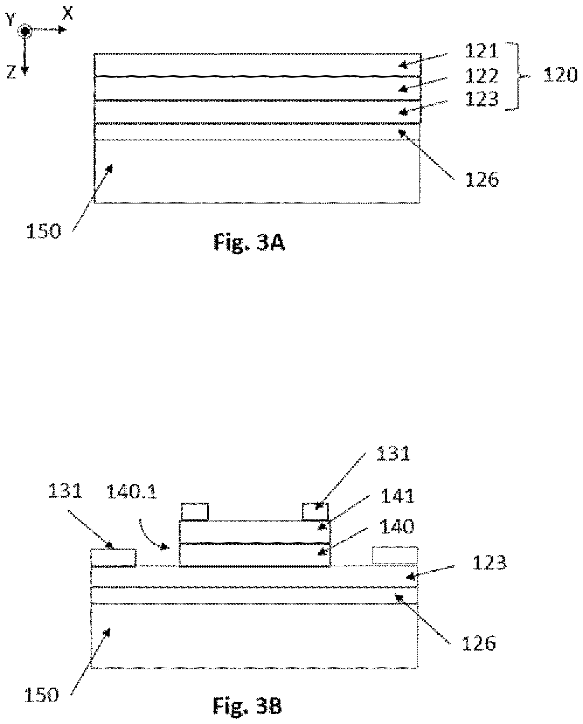

Un deuxième procédé de fabrication d'un dispositif optoélectronique va être décrit en lien avec les figures 1A, 1B, 3A à 3C. Le dispositif optoélectronique 1 peut être ici un laser ou une photodiode, aptes à, respectivement, émettre ou recevoir un flux lumineux dans un plan sensiblement parallèle au plan (X, Y). Seules les différences avec le premier procédé seront explicitement décrites.

En figure 1B, la première et la deuxième couches de collage 124.1, 124.2 sont en un diélectrique, ici de l'oxyde de silicium (SiOₓ) amorphe. A l'issue de l'assemblage du substrat accepteur 150 avec le substrat 100, la première couche de collage 124.1 et la deuxième couche de collage 124.2 définissent ensemble une couche isolante 126.

En figure 3B, on grave localement et partiellement la couche d'intérêt 120 par une gravure anisotropique, pour obtenir la couche d'intérêt structurée 120.1. La couche d'intérêt structurée 120.1 comprend un flanc de gravure 140.1 sensiblement perpendiculaire au plan (X, Y) qui délimite une région de la couche d'intérêt 120 destinée à être une région active 140 du dispositif optoélectronique 1. Le flanc de gravure 140.1 délimite également une première région dopée 141 du premier type de conductivité, issue de la sous-couche inférieure 121. La sous-couche supérieure 123 est conservée au moins sur une partie de sa hauteur, avantageusement en totalité. La première région dopée 141 et une partie de la sous-couche supérieure 123 en vis-à-vis de la première région dopée 141 et de la région active 140 sont destinées à devenir les régions dopées p et n, d'une diode PIN du dispositif optoélectronique 1. La région active 140 a une étendue surfacique dans un plan parallèle au plan (X, Y) délimitée par le flanc de gravure 140.1.

On réalise ensuite des portions métalliques 131 à l'aide d'étapes de photolithographie et de gravure classiques. Au moins une portion métallique 131 repose sur la première région dopée 141 et une autre portion métallique 131 repose sur une autre partie exposée de la couche d'intérêt 120 située sur la sous-couche supérieure 123.

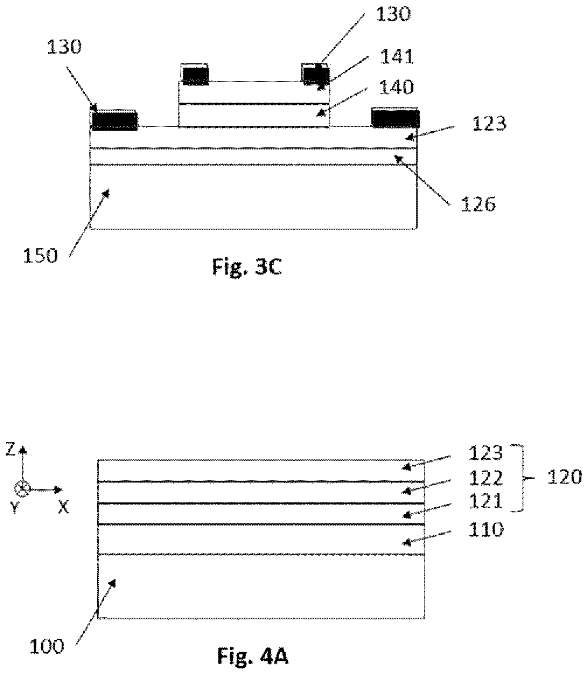

La figure 3C est une étape de réalisation d'un composé intermétallique 130. On chauffe dans un four la structure intermédiaire obtenue à l'issue des étapes de procédé de la figure 3B. Le budget thermique est suffisant pour créer le composé intermétallique 130 à partir de chaque portion métallique 131 en contact avec la couche d'intérêt structurée 120.1, comprenant du germanium, de l'étain et un métal de la portion métallique 131. On obtient ainsi des composés intermétalliques sur la sous-couche supérieure 123 et sur la première région dopée 141.

Tout comme pour le premier procédé de fabrication, la région active 140 a une étendue surfacique inférieure à une première surface maximale et la couche tampon 110 a été entièrement retirée, de sorte que l'étain de la région active 140 ne ségrègue pas lors de l'étape de réalisation du composé intermétallique 130. Le flanc de gravure 140.1 peut comprendre avantageusement un plan cristallin (110) de la couche d'intérêt 120 pour éviter l'éventuel phénomène entretenu de ségrégation de l'étain.

La première surface maximale est par exemple égale à 2,5.10⁻⁶ cm², pour une région active 140 comprenant 13 % d'étain.

Un troisième procédé de fabrication d'un dispositif optoélectronique va être à présent décrit en lien avec les figures 4A à 4C. Le dispositif optoélectronique 1 peut être ici un laser apte à émettre un flux lumineux dans un plan sensiblement parallèle au plan (X, Y). Seules les différences avec le premier procédé seront explicitement décrites.

L'étape de la figure 4A est identique à celle de la figure 1A. Le premier type de conductivité est ici de type p. Le substrat 100 comprend de plus une couche dopée du premier type de conductivité, en silicium ou à base de germanium, sur laquelle l'épitaxie de la couche tampon 110 est effectuée. La couche tampon 110 est dopée in-situ du premier type de conductivité.

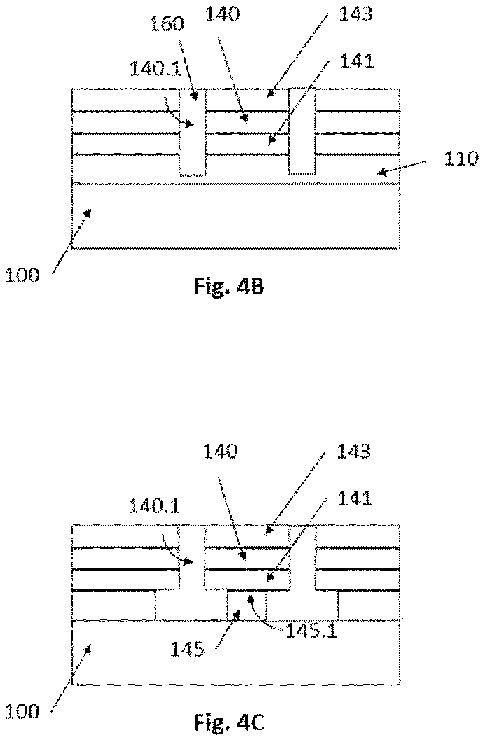

En figure 4B, la couche d'intérêt 120 est gravée par une gravure anisotropique sur toute sa hauteur pour obtenir au moins une ouverture traversante 160 exposant la couche tampon 110. Un flanc de gravure 140.1 sensiblement perpendiculaire au plan (X, Y) délimite une région de la couche d'intérêt 120 destinée à être une région active 140 du dispositif optoélectronique 1. La couche d'intérêt 120 est ici gravée par un plasma d'un mélange gazeux de CF₄, N₂ et O₂, au travers d'un masque de résine photosensible obtenue par photolithographie. Le flanc de gravure 140.1 délimite également une première région dopée 141 du premier type de conductivité, issue de la sous-couche inférieure 121, et une deuxième région dopée 143 du deuxième type de conductivité, issue de la sous-couche supérieure 123. Les première et deuxième régions dopées 141, 143 sont destinées à devenir les régions dopées p et n, d'une diode PIN du dispositif optoélectronique 1. La région active 140 a une étendue surfacique dans un plan parallèle au plan (X, Y) délimitée par le flanc de gravure 140.1.

En figure 4C, la couche tampon 110 est gravée de façon isotrope, sélectivement par rapport à la couche d'intérêt 120 et de manière avantageuse, sélectivement par rapport au substrat 100. Une partie résiduelle de la couche tampon 110 à l'issue de la gravure isotropique constitue un piédestal 145 sur lequel repose la première région dopée 141, sur une surface d'appui 145.1 de la couche tampon 110. La surface d'appui 145.1 est une interface de croissance de la couche d'intérêt 120 sur la couche tampon 110.

La gravure sélective isotropique est par exemple une gravure plasma de CF₄, N₂ et O₂, dans une chambre de gravure à une pression de 50.10⁻³ Torr, avec un débit gazeux de 30 sccm de CF₄, 40 sccm de N₂, 50 sccm d'O₂. Alternativement, une gravure isotrope par un plasma d'hexafluorure de soufre (SF6) peut être utilisée.

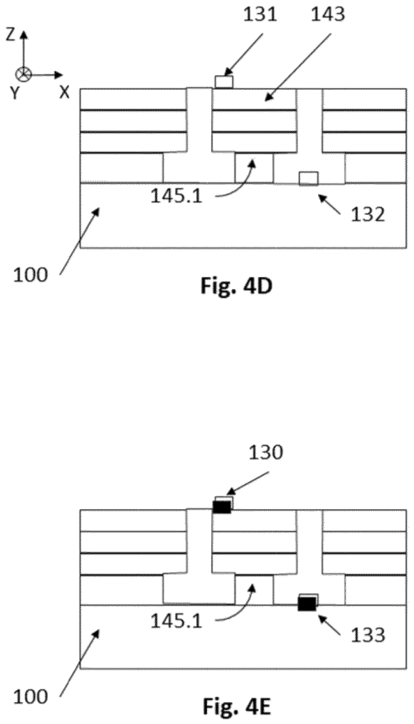

En figure 4D, on forme une portion métallique 131 sur la deuxième région dopée 143 et une portion métallique additionnelle 132 sur le substrat 100, par des étapes conventionnelles de l'industrie des semiconducteurs, par exemple similaires aux figures 2C à 2E.

La figure 4E est une étape de réalisation d'un composé intermétallique 130. On chauffe dans un four la structure intermédiaire obtenue à l'issue des étapes de procédé de la figure 4D. Le budget thermique est suffisant pour créer le composé intermétallique 130 à partir de la portion métallique 131 en contact avec la couche d'intérêt structurée 120.1, comprenant du germanium, de l'étain et un métal de la portion métallique 131. On obtient ainsi un composé intermétallique sur la première région dopée 141. Au cours de cette étape, on obtient également un composé intermétallique additionnel 133 sur le substrat 100. Si le substrat 100 est en germanium, le composé intermétallique additionnel 133 peut être du Ni(Pt)Ge. Si le substrat 100 est en silicium, le composé intermétallique additionnel 133 peut être du Ni(Pt)Si.

Tout comme pour le premier et le deuxième procédés de fabrication, l'étendue surfacique de la région active 140 est inférieure à une première surface maximale. La couche tampon 110 a de plus, partiellement été retirée, de sorte que la surface d'appui 145.1 est inférieure à une deuxième surface maximale. L'étain de la région active 140 ne ségrègue alors pas lors de l'étape de réalisation du composé intermétallique 130. Le flanc de gravure 140.1 peut aussi comprendre avantageusement un plan cristallin (110) ou (11̅0) de la couche d'intérêt 120 pour éviter l'éventuel phénomène entretenu de ségrégation de l'étain.

La première surface maximale et la deuxième surface maximale peuvent être établies par application de la procédure préalable décrite en lien avec les figures 6A à 6C, avec une deuxième couche 610 de même nature que la couche tampon 110 et une première couche 620 de même nature que la couche d'intérêt 120. Le budget thermique de l'étape de la figure 4E est appliqué pour le chauffage de l'étape de la figure 6C.

La première surface maximale et la deuxième surface maximale sont par exemple respectivement égales à 2,5.10⁻⁶ cm², et à 3.10⁻⁸ cm², pour une région active 140 comprenant 13 % d'étain et un budget thermique correspondant à une température de 400°C pendant 20 minutes. Pour une région active 140 comprenant 11 % d'étain, la première surface maximale est égale à 4,5.10⁻⁶ cm² pour un budget thermique de 400°C pendant 20 minutes, et égale à 1,8.10⁻⁶ cm² pour un budget thermique de 450°C pendant 20 minutes, la deuxième surface maximale étant supérieure ou égale à 3.10⁻⁸ cm² pour ces deux budgets thermiques. Pour une région active 140 comprenant 16 % d'étain, la première surface maximale et la deuxième surface maximale sont respectivement égales à 1,5.10⁻⁶ cm² et à 3.10⁻⁸ cm² pour un budget thermique de 400 °C pendant 20 minutes.

La région active 140 du dispositif optoélectronique 1 réalisée par l'un quelconque des premier, deuxième et troisième procédés de réalisation peut présenter une contrainte mécanique en compression, par exemple égale à -0,35 %. La concentration en étain pour obtenir un gap direct est alors typiquement supérieure à 13 %. La concentration moyenne de la couche d'intérêt 120 et de la région active 140 est par exemple comprise entre 13 % et 16 %.

Nous allons à présent décrire un quatrième procédé de fabrication d'un dispositif optoélectronique 1 selon l'invention, qui comprend cette fois-ci une région active 140 présentant une contrainte mécanique en tension et une concentration en étain supérieure à 8 %.

On réalise les étapes de figure 1A, 1B et 3A. La couche isolante 126 est ici en oxyde de silicium. On dépose ensuite une couche en nitrure de silicium présentant une contrainte mécanique en compression sur la sous-couche inférieure 121. La couche en nitrure de silicium est gravée sur toute sa hauteur pour réaliser un plot 570 présentant une contrainte mécanique en compression.

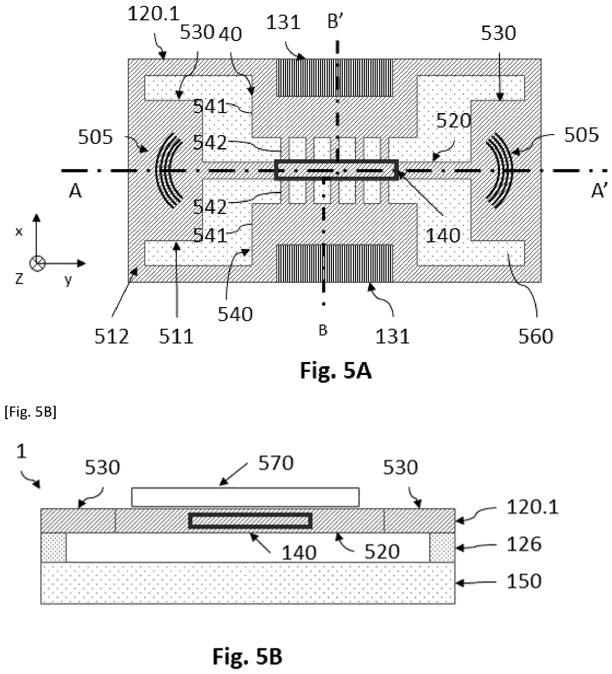

On grave ensuite localement la couche d'intérêt 120 sur toute son épaisseur par une gravure anisotropique, pour réaliser une ouverture traversante 560 exposant la couche isolante 126. La couche isolante 126 est ensuite gravée de façon isotropique, sélectivement par rapport à la couche d'intérêt 120 et au substrat accepteur 150, par exemple sous vapeur d'HF ou dans une solution d'HF. A l'issue de cette double gravure, on obtient une couche d'intérêt structurée 120.1 (figure 5A) qui comprend une partie structurée 511 suspendue au-dessus du substrat accepteur 150, et une partie périphérique 512 reposant sur une partie non gravée de la couche isolante 126. La partie structurée 511 comporte une portion centrale 520 reliée à la partie périphérique 512 par des premières portions latérales 530 formant des bras tenseurs, et par des deuxièmes portions latérales 540 formant des bras de polarisation électrique. La partie structurée 511 et la partie périphérique 512 constituent ensemble une couche d'intérêt structurée 120.1 issue de la couche d'intérêt 120. Le plot 570 repose entièrement sur la portion centrale 520 et est centré sur celle-ci.

La portion centrale 520 présente une forme allongée dans le plan (X, Y), dans le sens où elle présente une longueur suivant son axe longitudinal A-A' qui est supérieure à sa largeur. La longueur et la largeur sont les dimensions de la portion centrale 520 dans un plan parallèle au plan (X, Y). La forme de la portion centrale 520 dans ce plan peut être rectangulaire, polygonale, oblongue, ou autre. La longueur de la portion centrale 520 peut être de l'ordre de quelques dizaines de microns, et la largeur peut être de l'ordre de quelques microns. Dans le cas où la largeur locale de la portion centrale 520 varie suivant l'axe longitudinal A-A', la longueur est alors supérieure à la largeur moyenne. Les bras tenseurs 530 sont opposés l'un à l'autre vis-à-vis de la portion centrale 520 suivant l'axe longitudinal A-A'.

Ces bras tenseurs 530 sont dimensionnés de manière à induire, en association avec le plot 570, une déformation en tension dans la portion centrale 520 suivant l'axe longitudinal A-A'. Ils s'étendent donc longitudinalement à partir de la portion centrale 520, suivant l'axe longitudinal A-A', et plus précisément à partir des extrémités longitudinales de cette dernière. Aussi, l'axe longitudinal A-A' correspond à un axe de déformation principale de la portion centrale 520.

La portion centrale 520 étant contrainte en tension par les bras tenseurs 530, elle présente donc une déformation de sa structure cristallographique par augmentation de son paramètre de maille naturel suivant l'axe longitudinal A-A'. Les bras tenseurs 530 permettent d'augmenter la valeur non nulle de contrainte en tension dans la portion centrale 520 induite par le plot 570, de préférence sans pour autant subir eux-mêmes une contrainte mécanique significative. Pour cela, les bras tenseurs 530 sont dimensionnés de sorte que la largeur moyenne « b » des bras tenseurs 30 est supérieure à la largeur moyenne « a » de la portion centrale 520, de préférence dix fois supérieure à cette dernière. Par largeur, ou largeur locale, on entend la dimension locale d'une portion ou d'un bras, dans le plan (X, Y), suivant un axe transversal orthogonal à l'axe longitudinal A-A'. La largeur moyenne d'une portion peut alors être une moyenne de sa largeur locale calculée sur la longueur de la portion.

Les bras tenseurs 530 peuvent présenter une forme dans le plan (X, Y) sensiblement rectangulaire, avec une augmentation brusque de sa largeur à partir de la portion centrale 520, voire une forme de trapèze avec une largeur qui augmente continûment à mesure que l'on s'éloigne de la portion centrale 520. D'autres formes sont bien entendu possibles, comme une forme triangulaire.

La partie structurée 511 comporte en outre des deuxièmes portions latérales, formant des bras de polarisation 540. Au moins deux bras de polarisation 540 sont disposés de part et d'autre de la portion centrale 520, de manière opposée l'un à l'autre suivant un axe transversal, parallèle au plan (X, Y) et orthogonal à l'axe longitudinal A-A'. Ils s'étendent donc à partir des bordures latérales de la portion centrale 520 suivant l'axe transversal. Dans ce mode de réalisation, les bras de polarisation 540 participent, avec les bras tenseurs 530, à relier la portion centrale 520 à la partie périphérique 512.

Par ailleurs, chacun des bras de polarisation 540 comporte une partie principale 541 et une pluralité de parties de raccord 542, celles-ci assurant la liaison mécanique et électrique entre la partie principale 541 et la portion centrale 520. La partie principale 541 présente alors une largeur supérieure à celle de chaque partie de raccord 542. La largeur de la partie principale 541 est ici sa dimension dans un plan parallèle au plan (X, Y) et suivant l'axe A-A'. De plus, les parties de raccord 542 sont distribuées suivant l'axe A-A', avantageusement de façon uniforme. Les parties de raccord 542 s'étendent à partir d'une bordure latérale de la portion centrale 520 et délimitent ensemble une région continue le long de l'axe longitudinal A-A' de la sous-couche active 122 et de la portion centrale 520, destinée à être la région active 140 du dispositif optoélectronique 1. Par conséquent, la région active 140 a une étendue surfacique dans un plan parallèle au plan (X, Y) délimitée latéralement par des flancs de gravure 140.1 latéraux sensiblement orthogonaux au plan (X, Y) et parallèles à l'axe longitudinal A-A', et longitudinalement par la première partie de raccord 542 et la dernière partie de raccord 542, rencontrées le long de l'axe longitudinal A-A'. La contrainte mécanique et la concentration en étain de la région active 140 sont telles qu'elle présente un gap direct.

Une portion métallique 131 est formée sur une partie de la couche d'intérêt 120 au niveau de chaque partie principale 541 de chaque bras de polarisation 540. Plus précisément, une portion métallique 131 est formée sur une partie de la sous-couche supérieure 123 rendue accessible par une gravure locale de la sous-couche inférieure 121 et de la sous-couche active 122. Et, une portion métallique 131 est formée sur la sous-couche inférieure 121. Chaque portion métallique 131 comporte du titane (Ti) ou un alliage de nickel et de platine (NiPt) ou une bicouche de platine (Pt) et de nickel (Ni) en contact avec une partie de la couche d'intérêt 120.

On effectue ensuite l'étape de réalisation d'un composé intermétallique 130 de la figure 2F, appliquée à la structure obtenue après la formation des portions métalliques 131. On obtient alors un composé intermétallique 130 (figures 5B et 5C) sur une partie de la couche d'intérêt 120 au niveau de chaque partie principale 541 de chaque bras de polarisation 540. La partie principale 541 de chaque bras de polarisation 540 est destinée à polariser électriquement la région active 140 à partir des composés intermétalliques 130. Les figures 5B et 5C sont des vues schématiques, en coupe, respectivement, suivant l'axe A-A' et l'axe B-B', de la couche d'intérêt structurée 120.1 sur le substrat accepteur 150 de la figure 5A.

De préférence, pour améliorer la qualité de la polarisation électrique de la région active 140, les composés intermétalliques 130 sont partiellement chacun entourés par une ligne d'isolation électrique (non représentée). Une ligne d'isolation s'étend autour d'un composé intermétallique 130 entre celui-ci et la partie périphérique 512, et ne s'étend pas entre celui-ci et le bras de polarisation 540. Les lignes d'isolation peuvent être des tranchées traversantes de la couche d'intérêt 120.

Des réflecteurs optiques 505, par exemple des miroirs de Bragg, peuvent être disposés dans les bras tenseurs 530, de part et d'autre de la portion centrale 520, ceci afin de réaliser une diode laser à pompage électrique.

En première variante, il est possible de ne pas réaliser les étapes de la figure 1B et 3A. On dépose alors la couche en nitrure de silicium présentant une contrainte mécanique en compression sur la sous-couche supérieure 123. Et, on grave la couche tampon 110 de façon isotropique, sélectivement par rapport à la couche d'intérêt 120 et, de façon avantageuse, sélectivement par rapport au substrat accepteur 150, au lieu de graver la couche isolante 126. La partie de la couche tampon 110 en vis-à-vis de la région active 140 est par conséquent entièrement retirée lors de l'étape de réalisation des composés intermétalliques 130.

En deuxième variante, il est possible de déposer une couche en nitrure de silicium présentant une contrainte mécanique en tension au lieu de la couche en nitrure de silicium présentant une contrainte mécanique en compression. Le plot 570 est remplacé alors par deux plots 571 issus de la couche en nitrure de silicium reposant cette fois sur les bras tenseurs 530, centrés sur l'axe longitudinal A-A'. La deuxième variante peut être utilisée en combinaison avec la première variante.

En troisième variante, la couche d'intérêt 120 consiste en une couche unique à base d'un alliage de germanium et d'étain intrinsèque. Les bras de polarisation 540 sont alors préalablement implantés avant la formation des portions métalliques 131. Les bras de polarisation 540 présentent des types de dopage différents. Il n'est alors pas nécessaire de faire une gravure locale partielle pour rendre accessible une sous-couche de la couche d'intérêt 120 avant la formation des portions métalliques 131. La troisième variante peut être utilisée en combinaison avec la première variante et/ou la deuxième variante.

Pour les quatre procédés de fabrication qui viennent d'être décrits, ainsi que pour leurs variantes, les portions métalliques 131 en contact avec une partie de la couche d'intérêt 120 comportent avantageusement du titane (Ti) ou un alliage de nickel et de platine (NiPt) ou une bicouche de platine (Pt) et de nickel (Ni) en contact avec la couche d'intérêt 120, dans ce dernier cas, le platine est préférentiellement en contact avec la couche d'intérêt 120. Les composés intermétalliques 130 sont réalisés dans un four à une température Tᵢ strictement supérieure à la température d'épitaxie Tₑ de la couche d'intérêt 120. L'étape de réalisation des composés intermétalliques 130 participe à la suppression de défauts cristallins de la couche d'intérêt structurée 120.1, en complément ou en remplacement d'un recuit de guérison à une température strictement supérieure à la température d'épitaxie Tₑ de la couche d'intérêt 120. Parmi ces défauts, on compte par exemple des dislocations traversantes et/ou des lacunes et/ou des atomes interstitiels résultant de l'étape d'épitaxie de la couche d'intérêt 120.

Pour les quatre procédés de fabrication, ainsi que pour leurs variantes, si la portion métallique 131 comporte un alliage de nickel et de platine (NiPt), la température Tᵢ est par exemple supérieure ou égale à 350 °C, pendant une durée supérieure à 10 s, par exemple égale à 30 s, ainsi le composé intermétallique 130 comprend une phase NiPt(GeSn) qui est peu résistive. Si la portion métallique 131 comporte du titane (Ti), comme cela est le cas dans cet exemple, la température Tᵢ est par exemple supérieure ou égale à 450 °C, pendant une durée supérieure à 10 s, par exemple égale à 30 s, ainsi le composé intermétallique 130 comprend une phase Ti₆(GeSn)₅ peu résistive. L'étape de réalisation des composés intermétalliques 130 est avantageusement effectuée dans un outil de chauffage thermique rapide (ou Rapid Thermal Annealing, RTA, en anglais).

Pour les quatre procédés de fabrication, ainsi que pour leurs variantes, lors de l'étape de réalisation des composés intermétalliques 130, la région active 140 a une étendue surfacique inférieure à une première surface maximale et la couche tampon 110 a une interface en vis-à-vis de la région active 140 inférieure à une deuxième surface maximale, de sorte que l'étain de la région active 140 ne ségrègue pas lors de l'étape de réalisation du composé intermétallique 130. Pour les premier, deuxième et quatrième procédés de réalisation avec report sur un substrat accepteur 150, la deuxième condition est assurée par le fait que la couche tampon 110 est entièrement retirée. Pour la première variante du quatrième procédé de fabrication, la région active 140 est dans la portion centrale 520 suspendue, par conséquent, sans partie résiduelle de la couche tampon 110 en vis-à-vis de la région active 140.

Pour les quatre procédés de fabrication, ainsi que pour leurs variantes, la première surface maximale et la deuxième surface maximale peuvent être établies par application de la procédure préalable décrite en lien avec les figures 6A à 6C, avec une deuxième couche 610 de même nature que la couche tampon 110 et une première couche 620 de même nature que la couche d'intérêt 120. Le budget thermique de l'étape de réalisation du composé intermétallique est appliqué pour le chauffage de l'étape de la figure 6C, éventuellement additionné d'un budget thermique pour la guérison de défauts dans la région active 140.

Pour les quatre procédés de fabrication, ainsi que pour leurs variantes, la région active 140 est délimitée par au moins un flanc de gravure 140.1. Le flanc de gravure 140.1 peut comprendre avantageusement un plan cristallin (110) de la couche d'intérêt 120 pour éviter l'éventuel phénomène entretenu de ségrégation de l'étain. Les tranchées 640.1 lors de la réalisation des structures de test de la procédure préalable présentent alors toutes avantageusement un plan cristallin (110) ou (110).

Pour les quatre procédés de fabrication, ainsi que pour leurs variantes, chaque structure de test de la procédure préalable a avantageusement une forme géométrique dans un plan principal de la couche d'intérêt 120 homothétique d'une forme de la couche d'intérêt structurée 120.1.

Enfin, pour les quatre procédés de fabrication, la différence entre la concentration minimale en étain de la couche d'intérêt 120 et la concentration maximale en étain de la couche tampon 110 peut être telle que la couche tampon 110 puisse être retirée, au moins en partie, par une gravure sélective de la couche tampon 110 par rapport à la couche d'intérêt 120. Une gravure isotrope par un plasma d'hexafluorure de soufre (SF6) peut graver une couche tampon 110 de concentration maximale en étain inférieure à 7 %, sélectivement par rapport à une couche d'intérêt 120 de concentration minimale en étain strictement supérieure à 7 %, par exemple supérieure ou égale à 8%. Une gravure isotrope par un plasma de tétrafluorure de carbone (CF4) peut graver une couche tampon 110 de concentration maximale en étain inférieure à 8 %, sélectivement par rapport à une couche d'intérêt 120 de concentration minimale en étain strictement supérieure à 8 %, par exemple supérieure ou égale à 9%. Une gravure d'un premier matériau est sélective par rapport à un deuxième matériau si le premier matériau est gravé au moins 5 fois plus vite que le deuxième matériau, préférentiellement au moins 10 fois plus vite.

Des modes de réalisation particuliers viennent d'être décrits. Différentes variantes et modifications apparaîtront à l'homme du métier. Il saura notamment parfaitement appliqués les procédés de fabrication pour obtenir un dispositif optoélectronique 1 comprenant une jonction PN en lieu et place d'une jonction PIN, la région active 140 étant alors parfaitement définie par sa fonction. Il apparaîtra également à l'homme du métier que la région active 140 peut comporter un ou plusieurs puits quantiques, par exemple par des sauts de la concentration en étain.

## Revendications

1. Procédé de fabrication d'un dispositif optoélectronique (1) comportant un contact ohmique, le procédé comprenant :
∘ une étape d'épitaxie d'une couche d'intérêt (120) à base d'un alliage de germanium et d'étain sur une couche de croissance (110) comprenant du germanium, à une température d'épitaxie Tₑ, telle qu'une concentration minimale en étain de la couche d'intérêt (120) est supérieure strictement à une concentration maximale en étain de la couche de croissance (110),
∘ une étape de formation d'une région active (140) dans la couche d'intérêt (120), d'étendue surfacique dans un plan parallèle à un plan principal de la couche d'intérêt (120) inférieure à une première surface maximale prédéterminée,
∘ un recuit de guérison de la région active pour supprimer des dislocations de la région active,
∘ une étape de retrait d'une partie au moins de la couche de croissance (110) de façon à ce qu'une surface (145.1) de la couche de croissance (110) en contact de la couche d'intérêt (120) et en vis-à-vis de la région active (140) soit inférieure à une deuxième surface maximale prédéterminée ou nulle,
∘ une étape de métallisation pour obtenir une portion métallique (131) comportant un métal choisi parmi le titane ou un alliage de platine et de nickel, reposant sur une partie de la couche d'intérêt (120),
∘ une étape de chauffage dans un four à une température Tᵢ strictement supérieure à la température d'épitaxie Tₑ, pour réaliser un composé intermétallique (130) du contact ohmique à partir de la portion métallique (131), comprenant du germanium, de l'étain et le métal ;
les étapes d'épitaxie, de formation de la région active, de retrait, de métallisation et de chauffage étant successives, et
la première surface maximale et la deuxième surface maximale étant telles que l'étain dans la région active (140) ne ségrègue pas lors de l'étape de chauffage et lors du recuit de guérison.

2. Procédé selon la revendication 1, dans lequel l'étape de retrait relâche une contrainte mécanique en compression dans la région active.

3. Procédé selon la revendication 2, dans lequel une concentration d'étain dans la région active (140) est supérieure à 13 %, et une compression résiduelle de la région active (140) à l'issue de l'étape de retrait est supérieure ou égale à -0,35 %.

4. Procédé selon l'une quelconque des revendications précédentes, dans lequel l'étape de retrait comprend un report de la couche d'intérêt (120) sur un substrat accepteur (150), suivi d'un retrait total de la couche de croissance (110).

5. Procédé selon la revendication 4, dans lequel le report est réalisé par une mise en contact d'une première couche de collage (124.1) comportant un métal reposant sur la couche d'intérêt (120), choisi parmi le titane ou un alliage de nickel et de platine, avec une deuxième couche de collage (124.2) en métal reposant sur le substrat accepteur (150).

6. Procédé selon l'une quelconque des revendications 1 à 3, dans lequel l'étape de retrait comprend une gravure anisotropique d'une ouverture traversante (160, 560) de la couche d'intérêt (120), suivie d'une gravure isotropique de la couche de croissance (110) au-travers de l'ouverture traversante (160, 560), sélective par rapport à la couche d'intérêt (120).

7. Procédé selon la revendication 6, dans lequel, à l'issue de la gravure isotropique, la couche de croissance (110) et la couche d'intérêt (120) définissent une interface ne présentant pas de partie en vis-à-vis de la région active.

8. Procédé selon la revendication 7, dans lequel la gravure anisotropique définit une partie périphérique (512) de la couche d'intérêt (120) comprenant l'interface, et une partie structurée (511) de la couche d'intérêt (120) comportant une portion centrale (520) comprenant la région active (140), reliée à la partie périphérique (512) par au moins deux bras tenseur (530) opposés l'un à l'autre vis-à-vis de la portion centrale (520), et la gravure isotropique induit une contrainte en tension de la portion centrale (520) par les bras tenseur (530).

9. Procédé selon l'une quelconque des revendications précédentes, dans lequel l'étendue surfacique de la région active (140) est délimitée par un flanc de gravure (140.1).

10. Procédé selon la revendication 9, dans lequel le flanc de gravure (140.1) comprend un plan cristallin (110) ou (110) de la couche d'intérêt (120).

11. Procédé selon l'une quelconque des revendications précédentes, dans lequel le métal est du titane et la température Tᵢ de l'étape de chauffage est supérieure à une température pour laquelle une phase Ti₆(GeSn)₅ se forme.

12. Procédé selon l'une quelconque des revendications 1 à 10, dans lequel le métal est un alliage de platine et de nickel et la température Tᵢ de l'étape de chauffage est supérieure à une température pour laquelle une phase NiPt(GeSn) se forme.

13. Procédé selon l'une quelconque des revendications précédentes, comprenant une procédure préalable de détermination de la deuxième surface maximale comprenant les étapes suivantes :
∘ épitaxie d'une première couche (620) à base de GeSn de même nature que la couche d'intérêt (120), sur une deuxième couche (610) de même nature que la couche de croissance (110),
∘ retrait d'une partie de la deuxième couche (610) pour réaliser un ensemble de structures de test (650) comprenant chacune une interface (645.1) entre la première et la deuxième couches (620, 610), les interfaces (645.1) étant de surfaces différentes,
∘ mise en oeuvre de l'étape de chauffage,
∘ repérage d'un sous-ensemble de l'ensemble de structures de test pour lequel l'étain dans la structure de test (650) a ségrégué,
∘ définition de la deuxième surface maximale à une valeur inférieure strictement à toutes les surfaces des interfaces des structures de test (650) du sous-ensemble.

14. Procédé selon l'une quelconque des revendications précédentes, dans lequel le recuit de guérison et l'étape de chauffage sont une seule et même étape.
